# DEMANDE DE BREVET EUROPEEN

(11) **EP 4 766 082 A1**
(43) Date de publication de la demande: **24.06.2026**
(21) Numéro de dépôt: 25224823.2
(22) Date de dépôt: 18.12.2025
(51) Int. Cl.: H10D 30/69, H10W 10/10, H10W 10/00, H10W 10/17

(54) **MÉTHODE D'APPLICATION DE CONTRAINTE A DES RÉGIONS SEMI-CONDUCTRICES PAR CONTRÔLE DU FLUX D'UNE COUCHE D'OXYDE ENFERMÉE**

(30) Priorité: 23.12.2024 FR 2415182
(71) Demandeur: COMMISSARIAT À L'ÉNERGIE ATOMIQUE ET AUX ÉNERGIES ALTERNATIVES, 75015 Paris (FR)
(72) Inventeur: JARJAYES, Sylvie, 38054 GRENOBLE Cedex 09 (FR); FENOUILLET-BERANGER, Claire, 38054 GRENOBLE Cedex 09 (FR)
(74) Mandataire: Santarelli

(57) **Abrégé**

Réalisation d'un dispositif à régions semi-conductrices contraintes (12a, 12b, 12c, 120b, 120c, 220a, 220d) comprenant :
a) revêtir une couche semi-conductrice (12) d'un substrat de type semiconducteur sur isolant, d'une couche (30) de mise en contrainte en un matériau amorphe ayant une contrainte intrinsèque en tension, puis
b) former dans la couche (30) de mise en contrainte, au moins une ouverture (33 ; 233₁, 233₂) en regard d'une première région semi-conductrice (12a ; 220a, 220d) de ladite couche semi-conductrice puis,
c) effectuer un recuit de fluage selon une durée et une température adaptées pour permettre le fluage de la couche isolante (11) du substrat et mettre sous tension la première région semi-conductrice.

## Description

### DOMAINE TECHNIQUE ET ART ANTERIEUR

La présente description concerne le domaine de la microélectronique et des dispositifs semi-conducteurs dotés d'une ou plusieurs régions semi-conductrices contraintes.

Elle vise particulièrement celui des procédés de réalisation de tels dispositifs et des procédés pour mettre en contrainte ou relaxer une région semi-conductrice.

Pour améliorer les performances de certains composants microélectroniques, en particulier les transistors, il peut être avantageux de prévoir de réaliser ces derniers en partie dans une couche de matériau semi-conducteur dans laquelle une contrainte mécanique en tension ou en compression est appliquée.

Par contrainte mécanique d'une couche semi-conductrice on entend que son matériau a son ou ses paramètre(s) de maille cristalline déformé.

Dans le cas où le paramètre de maille déformé est plus important que le paramètre dit « naturel » d'un matériau cristallin dans une direction donnée, celui-ci est dit en déformation en tension dans cette direction.

Lorsque le paramètre de maille déformé est plus petit que le paramètre de maille naturel, le matériau est dit en déformation compressive ou en compression.

A ces états de déformation mécanique, on associe des états de contraintes mécaniques.

Un matériau semi-conducteur soumis à un état de contrainte donné va voir sa structure de bande modifiée, ce qui va engendrer une modification des propriétés électriques de ce matériau, en particulier de la mobilité des porteurs dans ce matériau. Un même matériau semiconducteur sera affecté différemment suivant son type de dopage et son orientation cristallographique.

Ainsi, pour améliorer les performances des transistors, on peut prévoir de réaliser leur région de canal dans un matériau semi-conducteur ayant une contrainte mécanique biaxiale en tension ou en compression suivant qu'il s'agit d'un semiconducteur dopé de type p (les porteurs majoritaires étant des trous) ou dopé n (les porteurs majoritaires étant des électrons).

Pour appliquer une contrainte sur une région de matériau semi-conducteur, il est connu d'utiliser une méthode communément appelé de « BOX creep » (i.e. « fluage du BOX ») où l'on se sert d'une couche d'oxyde thermique communément appelée « BOX » (Pour « Buried Oxide » ou « oxyde enterré ») dans un substrat de type semi-conducteur isolant pour permettre d'appliquer une contrainte à une couche semi-conductrice.

Il s'agit de tirer parti de la forte baisse de la viscosité du BOX à haute température en effectuant un recuit thermique pendant lequel une relaxation des contraintes est possible du fait du fluage du BOX.

Le document US2008169508A1 utilise une telle méthode avec une couche de fluage ou de BOX particulière en BPSG ("BoroPhosphoSilicate Glass", i.e. verre de borophosphosilicate), dans un procédé où l'on forme par structuration d'une couche semi-conductrice un ilot semi-conducteur contraint en tension et un ilot semi-conducteur contraint en compression sur lesquels on a respectivement formé une couche de mise en contrainte à base de SiN ayant une contrainte intrinsèque en compression et une couche de mise en contrainte à base de SiN ayant une contrainte intrinsèque en tension, que l'on fait relaxer consécutivement à un traitement thermique de fluage permettant de modifier les propriétés viscoélastiques de la couche de BPSG.

Le procédé ici mis en œuvre a notamment pour inconvénient d'utiliser une couche de BOX dopée et de nécessiter la mise en œuvre de deux couches de nitrure différentes obtenues par des procédés différents pour contraindre différemment les zones N et P d'un substrat donné.

Le document US2020/0066909 A1 présente quant à lui un autre procédé dans lequel la méthode de fluage de BOX est utilisée cette fois sur une couche de BOX non-dopée ce qui nécessite l'utilisation des températures plus élevées pour réaliser les traitements thermiques de fluage. Cependant, en cas de traitement thermique à température élevée, en particulier supérieure à 600°C, il s'avère difficile de conserver la contrainte intrinsèque d'une couche de mise en contrainte en nitrure compressif.

Il se pose le problème de trouver un nouveau procédé, de préférence amélioré vis-à-vis d'au moins un des inconvénients mentionnés ci-dessus, permettant de modifier l'état de contrainte d'une ou plusieurs régions semi-conductrices de différents type (N ou P) tout en limitant le nombre d'étapes nécessaires pour cela.

### EXPOSÉ DE L'INVENTION

C'est par conséquent un but de la présente invention de proposer un procédé de modification de l'état de contrainte d'au moins une région semi-conductrice d'un dispositif semi-conducteur, le procédé comprenant, dans cet ordre, les étapes suivantes :
a) revêtir, une couche semi-conductrice « superficielle » d'un substrat de type semi-conducteur sur isolant, d'une couche de mise en contrainte, le substrat comprenant : une couche de support, une couche isolante reposant sur la couche de support et la couche semi-conductrice superficielle reposant sur la couche isolante puis,
b) former, dans la couche de mise en contrainte, au moins une ouverture traversant la couche de mise en contrainte et agencée en regard d'une première région semi-conductrice de la couche semi-conductrice superficielle tout en conservant au moins une portion de la couche de mise en contrainte sur et en regard d'au moins une partie du substrat disposée contre et en contact de la première région semi-conductrice, puis,
c) effectuer un recuit dit « de fluage » selon une durée et une température adaptées pour permettre le fluage de la couche isolante du substrat et relâcher la portion de la couche de mise en contrainte de sorte à modifier un état de contrainte de la première région semi-conductrice.

Avec un tel procédé on peut mettre en contrainte, ou augmenter la contrainte ou éventuellement relaxer une région semi-conductrice.

On modifie ici l'état de contrainte d'au moins une région de la couche superficielle sans devoir effectuer un nombre d'étapes important.

Typiquement, des zones d'isolation à base de matériau isolant telles que des tranchées d'isolation sont prévues.

Ainsi, avantageusement, à l'étape a), le substrat comporte des zones d'isolation à base de matériau isolant traversant la couche semi-conductrice « superficielle », en particulier des tranchées d'isolation agencées de part et d'autre d'une zone semi-conductrice dite « active » comprenant la première région semi-conductrice.

Le fait qu'à l'étape a), le substrat comporte déjà des zones d'isolation permet de maximiser la contrainte dans la première région semi-conductrice qui se trouve en regard de l'ouverture.

Avantageusement, l'ouverture agencée en regard de la première région semi-conductrice est centrée par rapport à une première tranchée d'isolation et à une deuxième tranchée parmi d'isolation disposées de part et d'autre de la première région semi-conductrice.

L'ouverture traversant la couche de mise en contrainte peut être réalisée de sorte à conserver une deuxième portion de la couche de mise en contrainte, la portion de la couche de mise en contrainte et la deuxième portion étant alors agencées de part et d'autre de l'ouverture.

La portion de la couche de mise en contrainte et la deuxième portion de la couche de mise en contrainte peuvent être agencées respectivement en regard d'une deuxième région semi-conductrice et d'une troisième région de la couche semi-conductrice superficielle disposées contre et en contact de la première région semi-conductrice, la deuxième région semi-conductrice et la troisième région semi-conductrice étant agencées de part et d'autre de la première région semi-conductrice.

La portion préservée de la couche de mise en contrainte peut être prévue de sorte à chevaucher la deuxième région semi-conductrice et la première tranchée d'isolation, tandis que la deuxième portion de la couche de mise en contrainte chevauche la troisième région semi-conductrice et la deuxième tranchée d'isolation.

On peut ainsi réaliser avantageusement des avec des régions contraintes différentes, en particulier tension et en compression sans devoir nécessairement déposer plusieurs couches différentes de mise en contrainte et devoir utiliser différents matériaux ayant des contraintes intrinsèques différentes.

Selon un mode de réalisation particulier, la couche de mise en contrainte dans laquelle on forme l'ouverture à l'étape b) comporte une contrainte en tension. Dans ce cas le recuit de fluage de la couche isolante du substrat et le relâchement des portions de la couche de mise en contrainte peuvent entrainer une mise en compression de la deuxième région semi-conductrice et de la troisième région semi-conductrice et une mise en tension de la première région semi-conductrice.

Selon une possibilité de mise en œuvre, la première région semi-conductrice appartient à une zone semi-conductrice dite « zone active » destinée à accueillir au moins un transistor de type N, et l'ouverture peut être réalisée de sorte à conserver une portion de la couche de mise en contrainte en regard d'une autre zone active, l'autre zone active étant destinée à accueillir un ou plusieurs transistors de type P.

Selon un mode de réalisation particulier, après formation de l'ouverture et préalablement au recuit de fluage, le procédé peut comprendre en outre le dépôt d'une deuxième couche de mise en contrainte sur la couche de mise en contrainte ainsi que sur la première région semi-conductrice.

Selon une possibilité de mise en œuvre, on peut former dans la couche de mise en contrainte une deuxième ouverture dévoilant une autre région semi-conductrice de ladite couche semi-conductrice superficielle, l'ouverture et la deuxième ouverture ayant des dimensions respectives différentes.

Selon un mode de réalisation dans lequel, préalablement à l'étape de recuit de fluage, une partie du substrat est revêtue par une deuxième couche de mise en contrainte différente de ladite couche de mise en contrainte et/ou d'épaisseur différente de la couche de mise en contrainte, le procédé peut comprendre en outre, préalablement à l'étape de recuit de fluage, la réalisation d'une ouverture dans la deuxième couche de mise en contrainte dévoilant une autre région semi-conductrice de la couche semi-conductrice superficielle.

Selon un mode réalisation particulier, le matériau de la couche de mise en contrainte peut être du nitrure de silicium contraint en tension.

Ici, on utilise une couche de mise en contrainte en matériau ayant une contrainte intrinsèque en tension qui, contrairement au nitrure contraint en compression, peut être préservée à haute température, et on structure cette couche pour permettre d'obtenir ensuite une région semi-conductrice contrainte en tension consécutivement au fluage.

Typiquement, la couche de mise en contrainte peut être prévue avec une épaisseur comprise entre 20 nm et 100 nm.

Selon une possibilité de mise en œuvre, le recuit de fluage à l'étape b) est effectué à une température comprise entre 900°C et 1200°C, en particulier pendant une durée comprise entre 1 et 30 minutes.

Selon un mode de réalisation particulier, la première région semi-conductrice est à base de Si, et dans lequel au moins une autre zone semi-conductrice du substrat revêtue par la couche de mise en contrainte est en SiₓGe₁₋ₓ (avec 0 < x < 1).

Avantageusement, cette au moins une autre zone semi-conductrice est enrichie en Germanium de la couche semi-conductrice superficielle, la couche semi-conductrice superficielle étant en silicium. Dans ce cas, le procédé peut comprendre, préalablement à l'étape a), des étapes de :
- formation d'un bloc en silicium germanium, sur l'autre zone semi-conductrice,
- oxydation thermique du bloc semi-conducteur en silicium germanium et de ladite couche semi-conductrice superficielle de sorte à réaliser un enrichissement en germanium de l'autre zone semi-conductrice.

Selon un autre aspect l'invention prévoit un procédé de réalisation d'un dispositif à transistors utilisant un procédé tel que défini plus haut et en particulier comprenant :
- la mise en œuvre d'un procédé tel que défini précédemment puis, après l'étape c) de recuit de fluage,
- le retrait de la couche de mise en contrainte, le procédé comprenant en outre, après retrait de la couche de mise en contrainte : la formation d'au moins un transistor dans la première région semi-conductrice et d'au moins un autre transistor dans une autre région semi-conductrice de la couche superficielle du substrat.

### BRÈVE DESCRIPTION DES DESSINS

La présente invention sera mieux comprise sur la base de la description qui va suivre et des dessins en annexe sur lesquels :
Les figures 1A, 1B, 1C et 1D servent à illustrer un exemple de réalisation d'un procédé selon l'invention, de réalisation d'une structure comportant une région semi-conductrice contrainte, ici en tension, avec de part et d'autre des régions semi-conductrices contraintes différemment, dans cet exemple en compression, ce à partir d'un substrat de type semi-conducteur sur isolant en mettant en œuvre une étape de fluage de BOX.
Les figures 1E et 1F servent à illustrer la réalisation de transistors de type N et de transistors de type P sur une telle structure.
Les figures 2A et 2B servent à illustrer une variante de réalisation dans laquelle on forme une région à base de silicium en tension et de part et d'autre des régions contraintes en compression en SiₓGe₁₋ₓ.
La figure 3 sert à illustrer une structure pour la mise en œuvre d'une condensation en Germanium afin de former des régions en SiₓGe₁₋ₓ destinées à être contraintes en compression.
La figure 4 sert à illustrer la mise en œuvre de plusieurs ouvertures dans une couche de mise en contrainte et en regard d'une même zone active afin de former dans cette zone active plusieurs portions contraintes en tension réparties en regard des ouvertures.
Les figures 5, 6, 7, 8, 9 et 10 servent à illustrer l'influence de différents paramètres sur le niveau et la répartition de contrainte(s) dans une zone active obtenues par mise en œuvre d'un procédé selon l'invention.
Les figures 11A, 11B et 11C servent à illustrer une variante de réalisation ;
La figure 12 sert à illustrer une variante de procédé dans lequel on prévoit sur différentes parties d'un substrat des couches de mise en contrainte à base de matériaux différents.
La figure 13 sert à illustrer une variante de procédé dans lequel on prévoit des couches de mise en contrainte d'épaisseurs respectives différentes sur différentes parties d'un substrat.
La figure 14 sert à illustrer une variante de procédé dans lequel on prévoit dans une couche de mise en contrainte des ouvertures de dimensions respectives différentes en regard de différentes parties d'un substrat.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation d'une structure tels que « avant », « arrière », « supérieure », « inférieure », « sur », « sous », « dessus », « dessous », « au-dessus », « au-dessous », s'appliquent en considérant que la structure est orientée de la façon illustrée sur les figures.

### EXPOSÉ DÉTAILLÉ DE MODES DE RÉALISATION PARTICULIERS

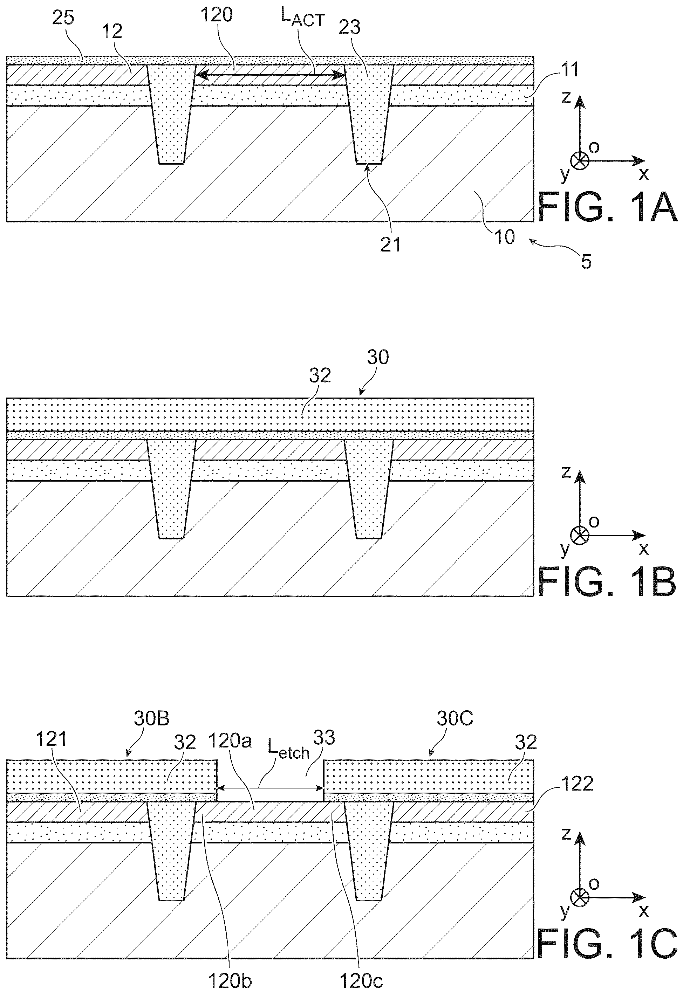

On se réfère à présent à la figure 1A qui donne un exemple de structure de départ d'un procédé de réalisation d'un dispositif semi-conducteur comportant une ou plusieurs régions semi-conductrices contraintes et ici en particulier au moins une région semi-conductrice contrainte en tension.

La structure comprend un substrat 5 de type semi-conducteur sur isolant, par exemple de type SOI (SOI pour « silicon on insulator », i.e. « silicium sur isolant »). Le substrat 5 est ainsi doté d'une couche de support 10, typiquement semi-conductrice, qui peut être à base de silicium, ainsi qu'une couche isolante 11, qui est disposée sur et en contact avec la couche de support 10, et une couche semi conductrice 12 dite « superficielle » située sur et en contact avec ladite couche isolante 11 et dans laquelle, typiquement, des transistors sont destinés à être formés.

La couche semi conductrice 12 superficielle peut avoir une épaisseur comprise par exemple entre 5 et 20 nm, de préférence entre 5 et 10 nm.

La couche isolante 11 est typiquement à base d'oxyde de silicium, de préférence non-dopé ou non intentionnellement dopé. Cette couche isolante 11 peut être prévue avec une épaisseur comprise par exemple entre 10 et 30 nm, de préférence entre 15 et 25 nm.

Des zones d'isolation permettant de délimiter plusieurs zones actives peuvent être également réalisées dans et/ou sur le substrat 5.

Dans l'exemple de réalisation particulier de la figure 1A, ces zones d'isolation sont sous forme de tranchées 21 d'isolation STI (pour "Shallow Trench Isolation", i.e. « tranchées d'isolation peu profondes »). Pour fabriquer de telles tranchées d'isolation, on creuse des tranchées à travers la couche semi-conductrice 12 « superficielle », la couche isolante 11, et dont le fond se situe au niveau de la couche de support 10. Puis, on remplit ces tranchées 21 à l'aide d'un matériau isolant 23, par exemple de l'oxyde de silicium.

En variante, des zones d'isolation d'un autre type peuvent être prévues. Par exemple, des zones d'isolation dites « mésa » impliquant la fabrication de structures isolantes sur la surface de la couche semi-conductrice superficielle 12 peuvent être réalisées.

Une zone semi-conductrice 120 située entre les tranchées 21 d'isolation peut être prévue pour former une zone active dans laquelle un ou plusieurs transistors sont destinés à être formés, en particulier des transistors de type N. Une telle zone 120 peut avoir une longueur L_{ACT} (dimension ici mesurée d'une zone STI à une autre et parallèle à l'axe x d'un repère orthogonal [O°;x°;y°;z°] comprise par exemple entre 100 nm et 10000 nm et correspondant typiquement à des dimensions prévues par des règles de dessins d'un nœud technologique visé.

Dans l'exemple de réalisation particulier illustré sur la figure 1A, le substrat 5 est également revêtu d'une fine couche isolante 25 qui peut être ici par exemple à base de SiO₂. La fine couche isolante 25 peut être réalisée après dépôt du matériau 23 puis planarisation par CMP (« Chemical Mechanical Planarization », i.e. « Polissage Mécano-Chimique »), retrait d'un masque dur par exemple à base de nitrure utilisé pour effectuer un polissage CMP.

Une telle fine couche isolante 25 peut jouer le rôle de tampon et servir à empêcher une éventuelle dégradation de la couche semi-conductrice superficielle 12 en empêchant notamment une apparition de dislocations, en particulier lors d'étapes ultérieures de recuit, en particulier à haute température.

On forme ensuite une couche 30 de mise en contrainte en un matériau 32 ayant une contrainte en tension (figure 1B). Par exemple, une telle couche peut être formée par une technique de type CVD (pour « Chemical vapor de position », i.e. « dépôt chimique en phase vapeur ») ou de LPCVD (pour «Low Pressure Chemical Vapor Deposition », « dépôt chimique en phase vapeur à basse pression ») ou de PECVD (« Plasma Enhanced CVD », i.e. CVD assisté par plasma). La couche 30 de mise en contrainte peut être déposée avec une contrainte intrinsèque, en particulier une contrainte en tension.

Ainsi, le matériau 32 peut être par exemple du nitrure de silicium (SiₓN_{y}) avec une contrainte intrinsèque en tension. Cette contrainte peut être par exemple comprise entre 0.5 GPa et 1.5 GPa pour une couche 30 de mise en contrainte prévue avec une épaisseur qui peut être comprise par exemple entre 20 nm et 100 nm.

On forme ensuite, dans la couche 30 de mise en contrainte, une ouverture 33 traversant la couche de 30 de mise en contrainte. L'ouverture 33 dévoile ici une région semi-conductrice 120a de la couche semi-conductrice superficielle 12 qui est située entre les tranchées 21 d'isolation STI et appartient à la zone active 120. L'ouverture 33 réalisée est prévue avec une dimension critique L_{etch} (plus petite dimension de l'ouverture 33 dans un plan parallèle à l'axe x d'un repère orthogonal [O°;x°;y°;z°]) qui peut être comprise par exemple entre 10 nm et la longueur L_{ACT} de la première zone active. Avantageusement, on prévoit L_{etch} ≤ L_{act} - 10nm.

De préférence, on prévoit la dimension critique L_{etch} inférieure à la longueur L_{ACT} de la zone active. L'écart de dimension entre la dimension critique L_{etch} et la longueur L_{ACT} peut être prévu d'au moins une ou plusieurs dizaines de nanomètres. Par exemple, lorsque l'on met en œuvre une zone active de longueur L_{ACT} de l'ordre de 500 nm, on peut prévoir une ouverture de dimension critique L_{etch} de l'ordre de 400 nm.

Dans cet exemple de réalisation, on préserve des portions 30B, 30C de la couche 30 de mise en contrainte en regard respectivement de régions 120b, 120c de la zone semi-conductrice superficielle 120 disposées de part et d'autre de la région 120a dévoilée par l'ouverture 33. On prévoit ici avantageusement que les portions préservées 30B, 30C de la couche 30 de mise en contrainte et disposées de part et d'autre de l'ouverture 33 chevauchent à la fois les régions 120b, 120c de la zone semi-conductrice superficielle 120 et les tranchées d'isolation STI. Autrement dit, la portion 30B s'étend continument en regard de la région 120b de la zone semi-conductrice superficielle 120 et d'une tranchée 21 d'isolation STI, tandis que la portion 30C s'étend continument en regard de la région 120c de la zone semi-conductrice superficielle 120 et d'une autre tranchée 21 d'isolation STI.

L'ouverture 33 en regard de la région 120a est ici avantageusement centrée par rapport aux tranchées d'isolation STI, de sorte qu'elle se trouve à égale distance entre une première tranchée d'isolation STI et une deuxième tranchée d'isolation disposées de part et d'autre de la région 120a.

Une telle ouverture 33 peut être formée par photolithographie en réalisant un masquage à base de résine photosensible puis, par gravure en reproduisant des motifs réalisés par le masquage dans la couche 30 de mise en contrainte ici à base de nitrure et dans l'exemple particulier décrit ici, dans la fine couche isolante 25 optionnelle.

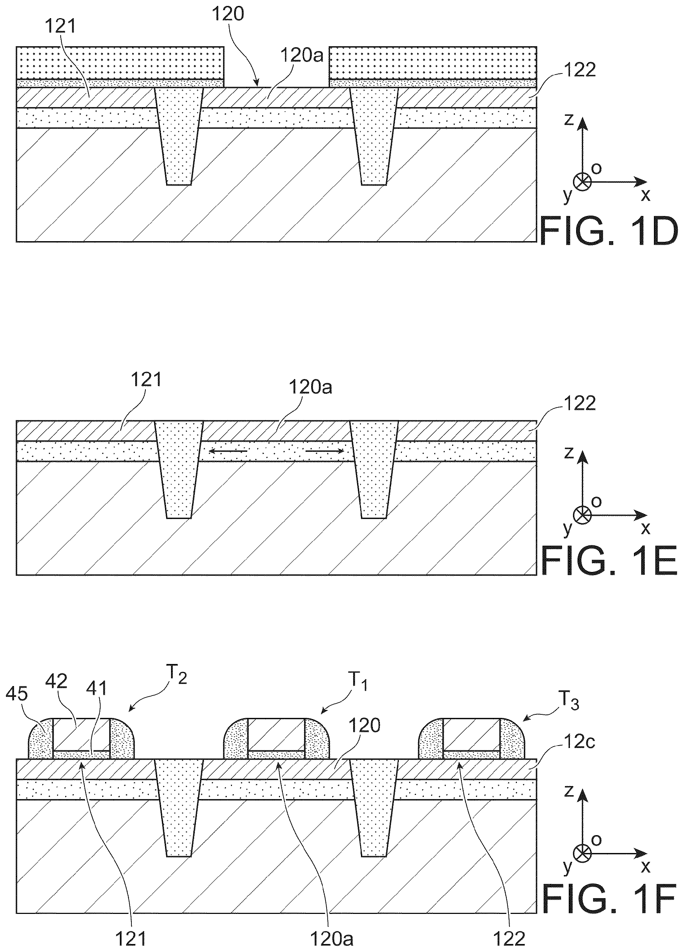

Ensuite (figure 1D), un traitement thermique, par exemple en four de recuit, est effectué à une température, de préférence élevée et, selon une durée, choisies de manière à modifier le comportement visco-élastique du matériau de la couche isolante 11 et en particulier de diminuer sa viscosité.

Pour provoquer le fluage de la couche isolante 11, on effectue de préférence le traitement de recuit à « haute température » c'est-à-dire au moins égale ou supérieure à 900°C. De préférence, la température de ce recuit est choisie inférieure à 1200°C afin de ne pas risquer d'endommager le substrat.

Le degré de déformation dû au fluage augmente à mesure que la durée du traitement de recuit à haute température augmente et à mesure que la température à laquelle le traitement de recuit à haute température est exécuté augmente.

Le fluage de la couche isolante 11 entraîne une modification de l'état de contrainte de la couche semi-conductrice 12. Du fait du recuit de fluage, les portions 30B, 30C de la couche de mise en contrainte en tension agencées de part et d'autre ont également tendance à se relâcher, ce qui favorise l'étirement de la maille du matériau de la région semi-conductrice 120a. La région semi-conductrice 120a en regard de laquelle la couche 30 de mise en contrainte a été retirée subit ainsi une contrainte en tension.

La durée de recuit peut être adaptée en fonction de la géométrie de la zone 120 et de la couche isolante 11 sous-jacente, et du type de matériau composant cette couche isolante 11. On peut prévoir la durée du recuit de fluage par exemple entre 1 et 30 minutes.

Un tel fluage favorise également le rétrécissement de la maille du matériau des régions semi-conductrices 120b, 120c et par conséquent une mise en compression des régions semi-conductrices 120b, 120c situées de part et d'autre de la région semi-conductrice 120a.

Le niveau de contrainte dans la couche semi-conductrice superficielle 12 et notamment de tension dans la région semi-conductrice 120a dépend, et peut être ajusté en fonction de l'épaisseur choisie de la couche 30 de mise en contrainte et/ou du niveau de contrainte intrinsèque du matériau 32, lui-même étant dépendant de paramètres du procédé de dépôt du matériau 32 que l'on peut ajuster.

Une fois avoir réalisé ce recuit de fluage, on peut ensuite retirer la couche 30 de mise en contrainte.

Un tel retrait peut être effectué par exemple par gravure sèche ou humide lorsque le matériau 33 est à base de nitrure de silicium.

Dans le cas où la fine couche isolante 25 recouvre la couche semi-conductrice superficielle 12, on retire ensuite également cette fine couche isolante 25 (figure 1E). Un tel retrait peut être réalisé par exemple par gravure à l'aide de HF ou d'un plasma utilisant un gaz fluoré, en particulier lorsque cette fine couche est en oxyde.

On peut ensuite former des transistors T₁, T₂, T₃, sur la structure obtenue et dotée d'au moins une région semi-conductrice contrainte 120a en tension.

On prévoit en particulier au moins un transistor T₁ de type N, dont le canal s'étend dans la région semi-conductrice 120a mise en tension et un ou plusieurs transistors T₂, T₃ de type P dans des zones semi-conductrices 121, 122 situées de part et d'autre de la zone semi-conductrice 120 et mises en compression consécutivement au recuit de fluage du fait du relâchement des portions 30B, 30C situées au-dessus de ces zones semi-conductrices 121, 122.

La réalisation des transistors peut comprendre notamment des étapes de formation d'un diélectrique 41 de grille et d'un bloc de grille 42 en regard de chacune des zones semi-conductrices 120, 121, 122 à l'aide d'étapes de dépôts, photolithographie et gravure, puis de formation d'espaceurs isolants de part et d'autre du bloc de grille (figure 1F). Un dopage des régions de source et de drain peut être alors effectué. Dans le cas où l'on prévoit de réaliser des régions de source et de drain dites « surélevées », on forme ces régions typiquement par croissance par épitaxie sur la couche semi-conductrice 12. Un dopage des régions de source et de drain peut être alors effectué au moins partiellement pendant l'étape d'épitaxie.

Selon une variante de réalisation d'un procédé tel que décrit précédemment et au lieu de mettre en compression des zones semi-conductrices 121, 122 d'une couche en silicium, pour améliorer les performances des transistors de type P, on peut prévoir de réaliser cette mise compression sur des régions de SiₓGe₁₋ₓ (avec 0 < x < 1).

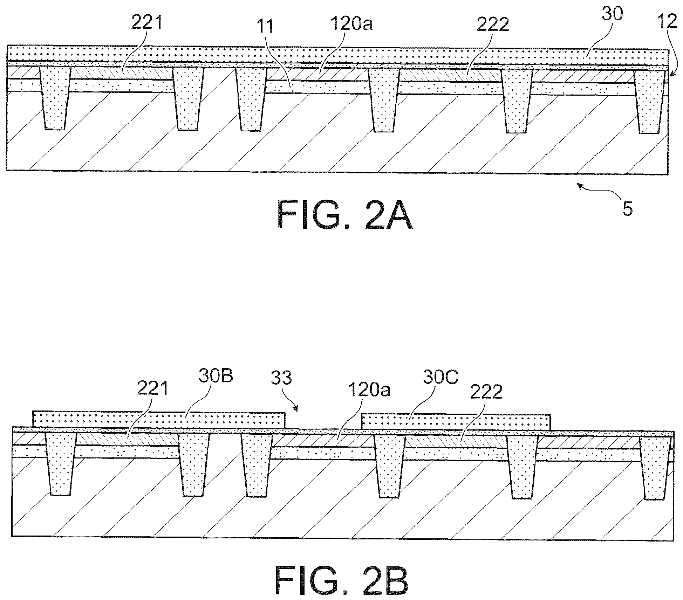

Ainsi, dans l'exemple de réalisation donné sur les figures 2A-2B, on forme tout d'abord (figure 2A), la couche 30 de mise en contrainte ayant une contrainte intrinsèque en tension et typiquement en nitrure de silicium sur une couche semi-conductrice comportant au moins une zone semi-conductrice 120 en silicium et, de part et d'autre de cette zone 120, des régions semi-conductrices 221, 222 en SiₓGe₁₋ₓ.

Puis, on forme au moins une ouverture 33 dans la couche 30 de mise en contrainte en face de la région semi-conductrice 120a et de manière à préserver des portions 30B, 30C de la couche 30 de mise en contrainte situées en face respectivement des zones semi-conductrices 221 et 222 en SiₓGe₁₋ₓ situées de part et d'autre de la zone semi-conductrice 120 en silicium (figure 2B).

On effectue ensuite un recuit de fluage selon une durée et une température adaptées pour permettre le fluage de la couche isolante 11 de BOX et provoquer une mise en tension de la région semi-conductrice 120a en regard de l'ouverture 33 tout en mettant en compression les régions semi-conductrices 221, 222 en SiₓGe₁₋ₓ situées en face des portions 30B, 30C de la couche 30 de mise en contrainte.

Une manière de réaliser les zones semi-conductrices 221, 222 en SiₓGe₁₋ₓ est d'effectuer un enrichissement en Germanium des régions d'une couche semi-conductrice superficielle 12 en silicium.

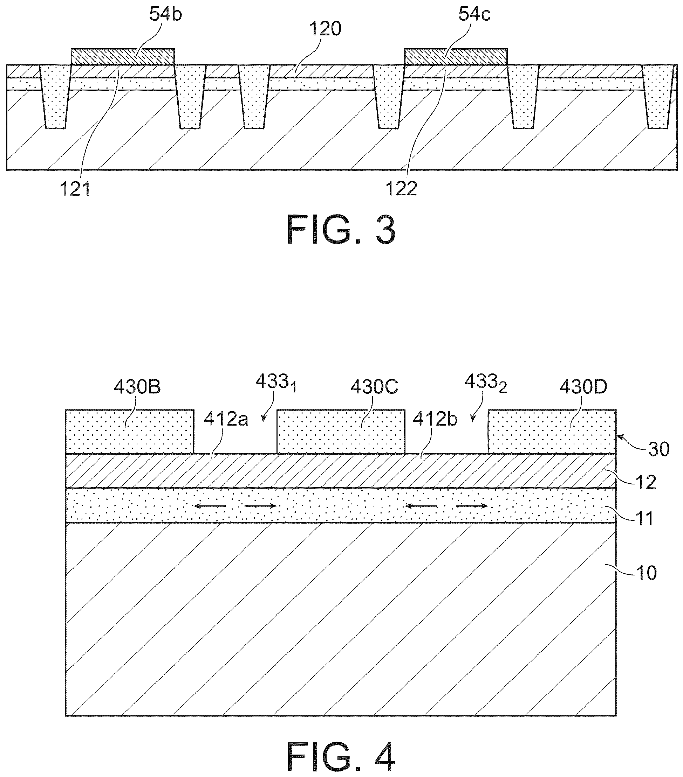

Pour cela, on peut partir d'un substrat 5 de type semi-conducteur sur isolant, éventuellement muni de zones d'isolation, en particulier de tranchées STI, et préalablement à la réalisation de la couche 30 de mise en contrainte on peut former des blocs 54b, 54c en silicium Germanium, respectivement sur des régions semi-conductrices 121, 122 de la couche semi-conductrice superficielle 12 du substrat 5 (figure 3).

De tels blocs peuvent être réalisés, par exemple, en déposant ou en faisant croitre une couche en silicium germanium sur la couche semi-conductrice superficielle 12 puis en formation de motifs dans cette couche de silicium germanium. Ensuite, une oxydation thermique des blocs semi-conducteurs 54b, 54c en silicium germanium est conduite pour permettre de faire migrer les atomes de germanium dans des portions de la couche superficielle et à réaliser un enrichissement en germanium de la couche semi-conductrice superficielle. Les documents EP2075826B1 et FR2908924A1 issus de la demanderesse donnent des exemples de procédé d'enrichissement en germanium, également appelé procédé de condensation en germanium, pour former des régions de SiₓGe₁₋ₓ à partir de blocs de silicium.

On peut ensuite retirer une épaisseur d'oxyde formée lors de l'étape de condensation germanium par exemple par nettoyage à base de HF.

En variante de ce qui vient d'être décrit, on peut également prévoir de réaliser les zones d'isolation telles que des tranchées STI après la formation des régions de SiₓGe₁₋ₓ par condensation ou enrichissement en Germanium.

On peut prévoir des transistors de type P dans les régions enrichies en germanium et contraintes en compression et un ou plusieurs transistors de type N dans la région préservée en silicium et que l'on a contraint en tension à l'aide du fluage.

Un exemple de réalisation particulier donné sur la figure 4, prévoit cette fois la réalisation de plusieurs ouvertures 433₁, 433₂ dans la couche 30 de mise en contrainte en regard d'une même zone active. Ainsi, on forme dans la couche 30 de mise en contrainte et entre des zones isolantes d'isolation, par exemple de type STI (non représentées sur la figure 4), plusieurs ouvertures 433₁, 433₂.

Dans l'exemple de réalisation illustré sur la figure 4, une première ouverture 433₁ est formée dans la couche de mise en contrainte 30 en regard d'une région semi-conductrice 412a de ladite couche semi-conductrice 12 superficielle et une deuxième ouverture 433₂ est formée dans la couche de mise en contrainte 30 en regard d'une autre région semi-conductrice 412b de ladite couche semi-conductrice 12 superficielle. On préserve de part et d'autre de ces régions semi-conductrices 412a, 412b dévoilées par les ouvertures 433₁, 433₂, des portions 430B, 430C et 430C, 430D de la couche 30 de mise en contrainte.

On effectue ensuite le recuit haute température selon une durée et une température adaptées pour permettre le fluage de la couche isolante 11 du substrat et relâcher les portions 430B, 430C, 430C, 430D, de la couche 30 de mise en contrainte. On met ainsi en tension des régions semi-conductrices 412a, 412b situées en regard des ouvertures 433₁, 433₂. On obtient ainsi plusieurs régions mises en tension dans des zones particulières d'une zone active.

Un tel agencement et une telle répartition des contraintes peut être mise en œuvre pour des applications particulières par exemple lorsque l'on réalise un transistor uniquement en regard des régions 412a, 412b mises sous tension.

Comme indiqué précédemment, le niveau et la répartition des contraintes dans les régions de la couche superficielle semi-conductrice 12 peut être adapté en fonction de certains paramètres de la couche 30 de mise en contrainte et de la ou les ouvertures réalisées dans cette couche.

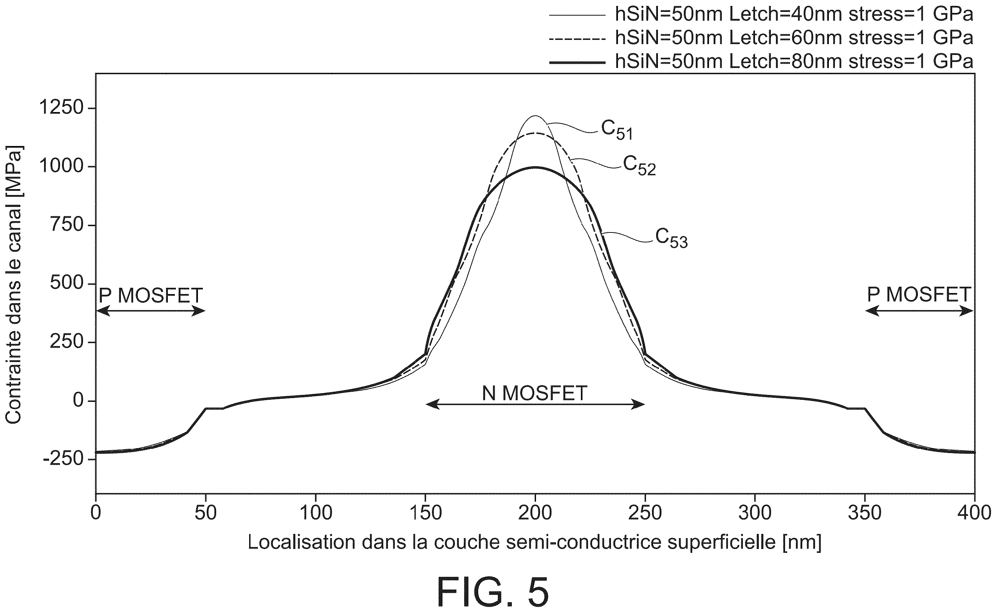

La figure 5 donne différentes courbes C₅₁, C₅₂, C₅₃ représentatives de l'évolution d'un niveau de contrainte dans la couche semi-conductrice superficielle 12 obtenues ici par simulation à l'aide de l'outil Ansys Mechanical^{™} pour une couche de mise en contrainte 30 à base de nitrure ayant une épaisseur de 50 nm en fonction de la position dans cette couche semi-conductrice superficielle 12, et pour différentes dimensions critiques L_{etch} d'ouverture respectivement de 40 nm, 60 nm et 80 nm. Le niveau de contrainte varie ainsi peu en fonction de la valeur de la dimension critique L_{etch} de l'ouverture.

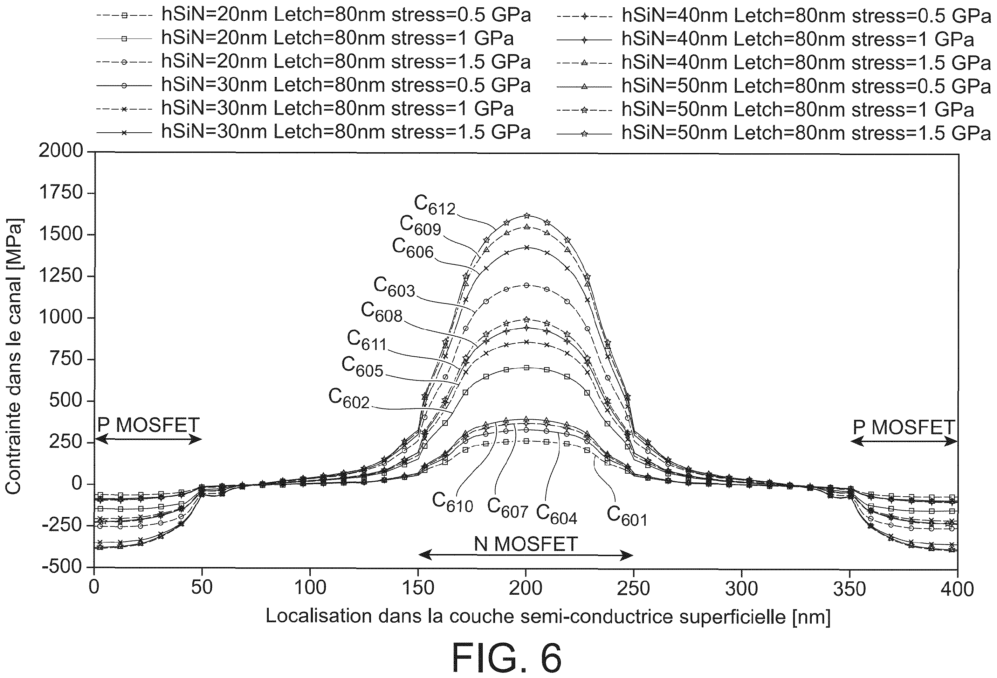

La figure 6 donne quant à elle différentes courbes C₆₀₁, C₆₀₂, C₆₀₃, C₆₀₄, C₆₀₅, C₆₀₆, C₆₀₇, C₆₀₈, C₆₀₉, C₆₁₀, C₆₁₁, C₆₁₂, C₆₁₃ représentatives de l'évolution d'un niveau de contrainte dans une zone active de longueur L_{act} de 100 nm en fonction de la position dans cette couche semi-conductrice superficielle 12, la contrainte étant obtenue à l'aide d'une couche de mise en contrainte 30 à base de nitrure dans laquelle l'ouverture 33 a une dimension critique L_{etch} de 80 nm et pour un recuit de fluage réalisé à 1050°C pendant 600 secondes. Ces courbes sont obtenues pour différentes épaisseurs, respectivement de 20 nm (courbes C₆₀₁, C₆₀₂, C₆₀₃), de 30 nm (courbes C₆₀₄, C₆₀₅, C₆₀₆), de 40 nm (courbes C₆₀₇, C₆₀₈, C₆₀₉) et 50 nm de la couche de mise en contrainte 30 et différents niveaux de contrainte intrinsèque respectivement de 0.5 GPa (courbes C₆₀₁, C₆₀₄, C₆₀₇, C₆₁₀), de 1 GPa (courbes C₆₀₂, C₆₀₅, C₆₀₈, C₆₁₁), de 1.5 GPa (courbes C₆₀₃, C₆₀₆, C₆₀₉, C₆₁₂). Cette figure 6 montre l'influence de l'épaisseur de la couche de mise en contrainte et du niveau de contrainte intrinsèque dans cette couche pour permettre un transfert de contrainte adéquat dans la couche superficielle semi-conductrice.

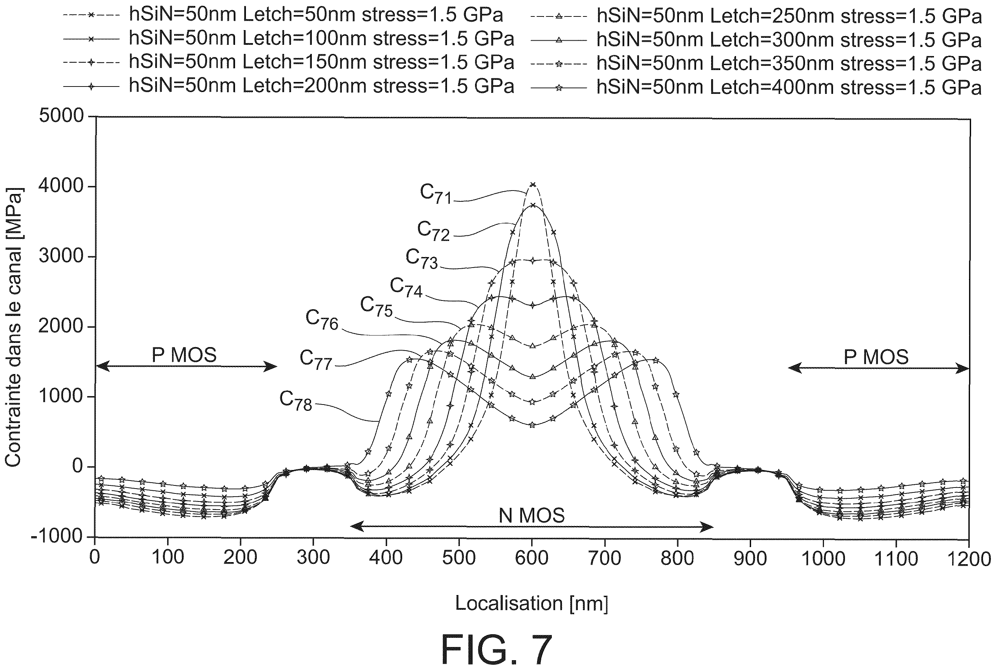

La figure 7 donne quant à elle différentes courbes C₇₁, C₇₂, C₇₃, C₇₄, C₇₅, C₇₆, C₇₇, C₇₈, représentatives de l'évolution d'un niveau de contrainte dans une zone active de longueur L_{act} de 500 nm en fonction de la position dans cette couche semi-conductrice superficielle 12, la contrainte étant obtenue à l'aide d'une couche de mise en contrainte 30 à base de nitrure d'épaisseur de 50 nm, un niveau de contrainte intrinsèque de 1.5 GPa et pour différentes dimensions critiques L_{etch}, respectivement de 50 nm, 100 nm, 150 nm, 200 nm, 250 nm, 300 nm, 350 nm, 400 nm. Cette figure enseigne qu'il est préférable montre l'impact du choix de la dimension critique L_{etch} sur le profil de contraintes obtenu.

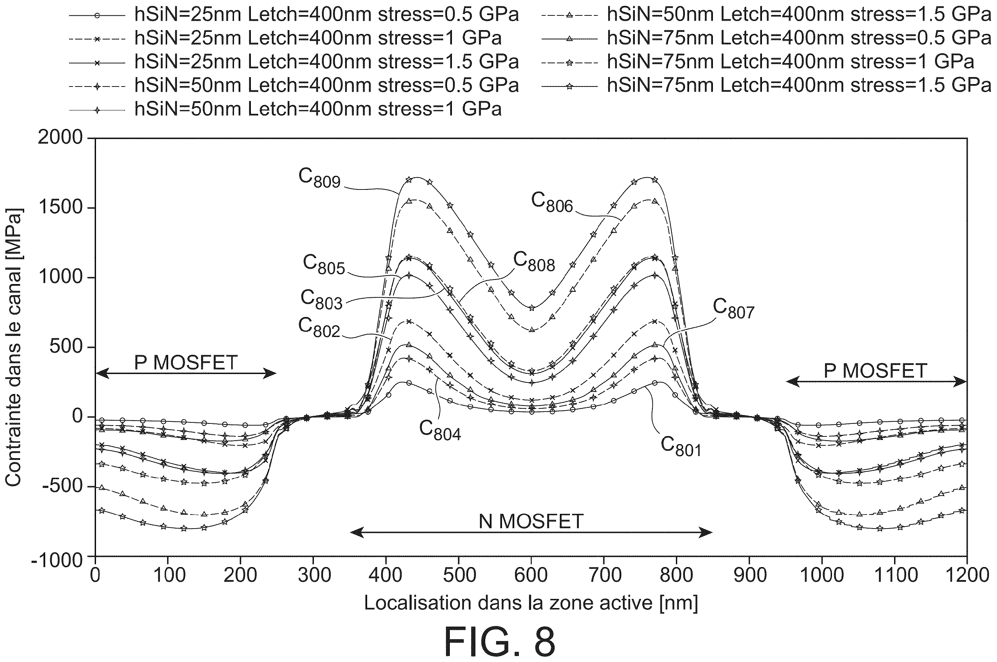

La figure 8 donne différentes courbes C₈₀₁, C₈₀₂, C₈₀₃, C₈₀₄, C₈₀₅, C₈₀₆, C₈₀₇, C₈₀₈, C₈₀₉, représentatives de l'évolution d'un niveau de contrainte dans une zone active de longueur L_{act} de 500 nm en fonction de la position dans cette couche semi-conductrice superficielle 12, la contrainte étant obtenue à l'aide d'une couche de mise en contrainte 30 à base de nitrure dans laquelle au moins une ouverture est pratiquée et pour un recuit de fluage réalisé à 1050°C pendant 600 secondes. Ces courbes sont obtenues pour différentes épaisseurs respectivement de 25 nm (courbes C₈₀₁, C₈₀₂, C₈₀₃), de 50 nm (courbes C₈₀₄, C₈₀₅, C₈₀₆), de 75 nm (courbes C₈₀₇, C₈₀₈, C₈₀₉) et différents niveaux de contrainte intrinsèque respectivement de 0.5 GPa (courbes C₈₀₁, C₈₀₄, C₈₀₇), de 1 GPa (courbes C₈₀₂, C₈₀₅, C₈₀₈), de 1.5 GPa (courbes C₈₀₃, C₈₀₆, C₈₀₉). Là encore, cette figure montre l'influence de l'épaisseur de la couche de mise en contrainte et du niveau de contrainte intrinsèque dans cette couche.

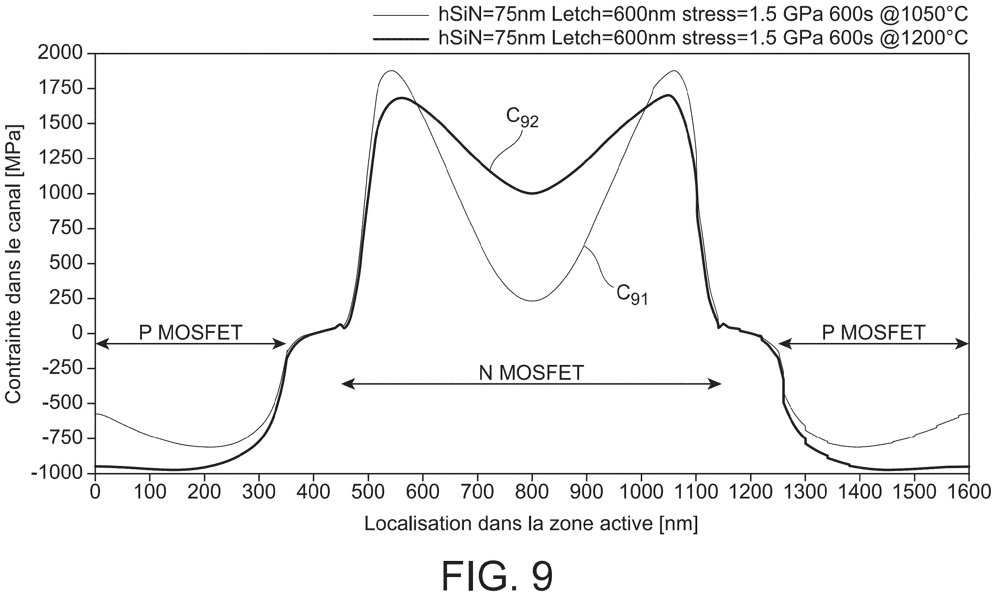

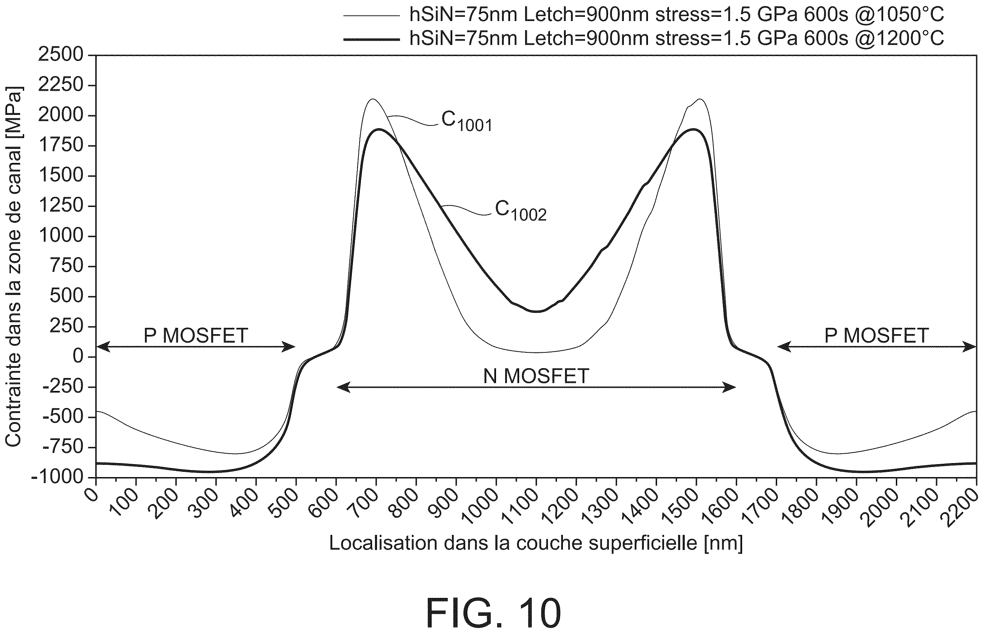

Les courbes C₉₁, C₉₂ de la figure 9 et celles C₁₀₀₁, C₁₀₀₂ de la figure 10 servent quant à elles à illustrer l'impact de la température de recuit de fluage sur le niveau de contrainte dans une zone active de longueur L_{act} de 700 nm (courbes C₉₁, C₉₂) ou dans une zone active de longueur L_{act} de 1000 nm (courbes C₁₀₀₁, C₁₀₀₂), la contrainte étant obtenue à l'aide d'une couche de mise en contrainte 30 à base de nitrure de 75 nm d'épaisseur et un niveau de contrainte intrinsèque de 1.5 GPa. Ces courbes sont obtenues pour un recuit effectué pendant une durée de l'ordre de 600 secondes et des températures respectivement de 1050°C (courbe C₉₁, C₁₀₀₁) et 1200°C (courbe C₉₂, C₁₀₀₂). Ainsi, une augmentation de la température de fluage va dans le sens de l'augmentation de la contrainte au centre de la région semi-conductrice mise en tension.

Dans l'un ou l'autre des exemples de réalisation qui viennent d'être décrits on prévoit une couche de mise en contrainte à base d'un matériau présentant une contrainte en tension, ici en particulier du SiN en tension. Le procédé peut s'appliquer également pour des couches de mise en contrainte différentes, par exemple à base de matériau présentant une contrainte en compression comme du carbone amorphe ou du TiN. La couche de mise en contrainte peut être à base de matériau amorphe ou bien une couche de matériau semi-conducteur, par exemple du SiGe, que l'on fait croitre sur la couche superficielle 12.

Dans l'exemple de réalisation qui vient d'être décrit, on prévoit une mise en tension d'une région semi-conductrice initialement relaxée ou sans contrainte. Le procédé peut s'appliquer également à une augmentation d'une contrainte d'une région présentant déjà une contrainte voire à une relaxation d'une région initialement contrainte. Par exemple, un procédé tel que décrit précédemment peut s'appliquer à la relaxation d'une couche de silicium qui se trouve initialement mise en compression par exemple par croissance de SiGe suivi d'un procédé de condensation ou en prévoyant un substrat particulier.

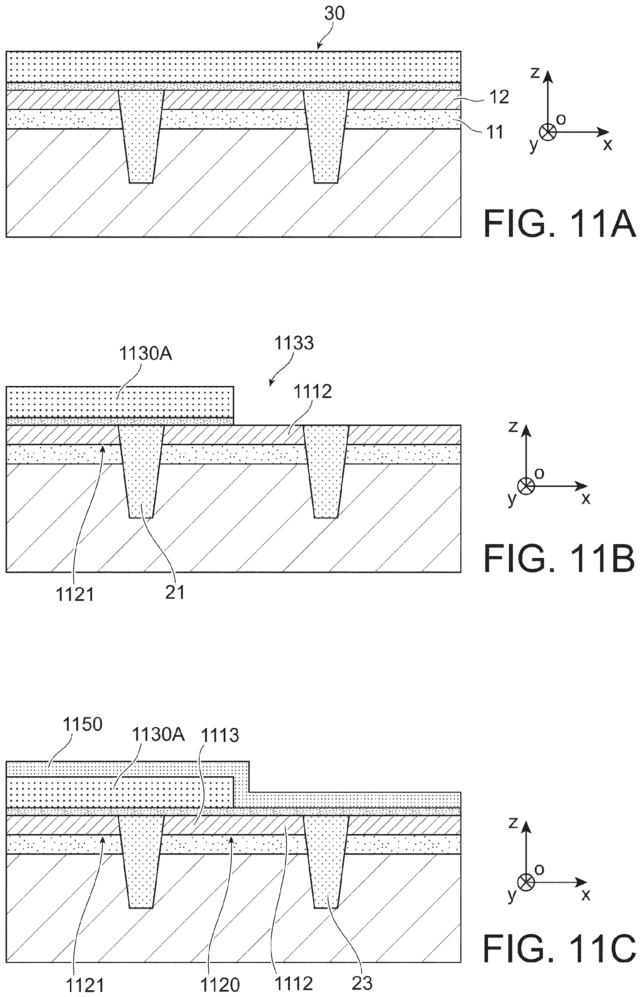

Une variante de procédé de modification de l'état de contrainte d'une région semi-conductrice 1120 appartenant à une couche semi-conductrice 12 superficielle d'un substrat de type semi-conducteur sur isolant est illustrée sur les figures 11A-11C.

Un dépôt « pleine plaque » d'une couche 30 de mise en contrainte (figure 11A), c'est-à-dire sur toute l'étendue du substrat 5, est effectué. La couche 30 de mise en contrainte peut être par exemple une couche de SiN telle que décrite précédemment.

On forme ensuite une ouverture 1133 (figure 11B) dans la couche 30 de mise en contrainte en regard d'une région semi-conductrice 1112 de ladite couche semi-conductrice superficielle 12 tout en conservant une portion 1130A de la couche 30 de mise en contrainte en regard d'une partie du substrat qui est disposée contre et en contact de la région semi-conductrice 1112. Cette partie du substrat recouverte par la portion 1130A comprend une zone semi-conductrice 1121 distincte et dans cet exemple particulier séparée de la région semi-conductrice 1112 par le biais d'une tranché d'isolation 21.

On dépose ensuite (figure 11C) une deuxième couche 1150 de mise en contrainte sur la couche 30 de mise en contrainte ainsi que sur la région semi-conductrice 1112 dévoilée par l'ouverture 1133. Selon un exemple de réalisation particulier, la deuxième couche 1150 de mise en contrainte peut être également à base de nitrure de silicium (SiₓN_{y}) avec une contrainte intrinsèque en tension, par exemple comprise entre 0.5 GPa et 1.5 GPa pour une épaisseur qui peut être comprise par exemple entre 20 nm et 100 nm. En variante, il est possible de prévoir les couches 30, 1150 de mise en contrainte avec des épaisseurs et/ou à base de matériaux respectifs différents.

On réalise ensuite un recuit de fluage selon une durée et une température adaptées pour permettre le fluage de la couche isolante 11 du substrat et relâcher à la fois la portion 1130A de la couche 30 de mise en contrainte et la deuxième couche 1150 de mise en contrainte.

Avec une telle variante, on peut obtenir une zone semi-conductrice 1120, ayant une contrainte asymétrique ou tout du moins non uniformément répartie entre les tranchées d'isolation 21, dans la mesure où, lors du recuit de fluage, la région semi-conductrice 1112 elle est revêtue uniquement de la deuxième couche 1150 de mise en contrainte, tandis qu'une autre région 1113 est revêtue d'un empilement des couches 30, 1150 de mise en contrainte.

Avec une telle variante, on peut également obtenir des zones actives avec des contraintes respectives différentes. Une zone semi-conductrice 1120, ici en regard uniquement de la deuxième couche 1150 de mise en contrainte et une autre zone semi-conductrice 1121 en regard d'un empilement de la portion 1130A et deuxième couche 1150 ont, à l'issue du recuit de fluage des états de contraintes différents.

Pour mettre en œuvre des zones semi-conductrices avec des contraintes différentes dans la couche superficielle 12 d'un même substrat, une variante de réalisation prévoit de réaliser la couche 30 de mise en contrainte sur une partie du substrat et, sur une autre partie du substrat, une deuxième couche 1230 de mise en contrainte différente de la couche 30 de mise en contrainte et en particulier à base d'un autre matériau.

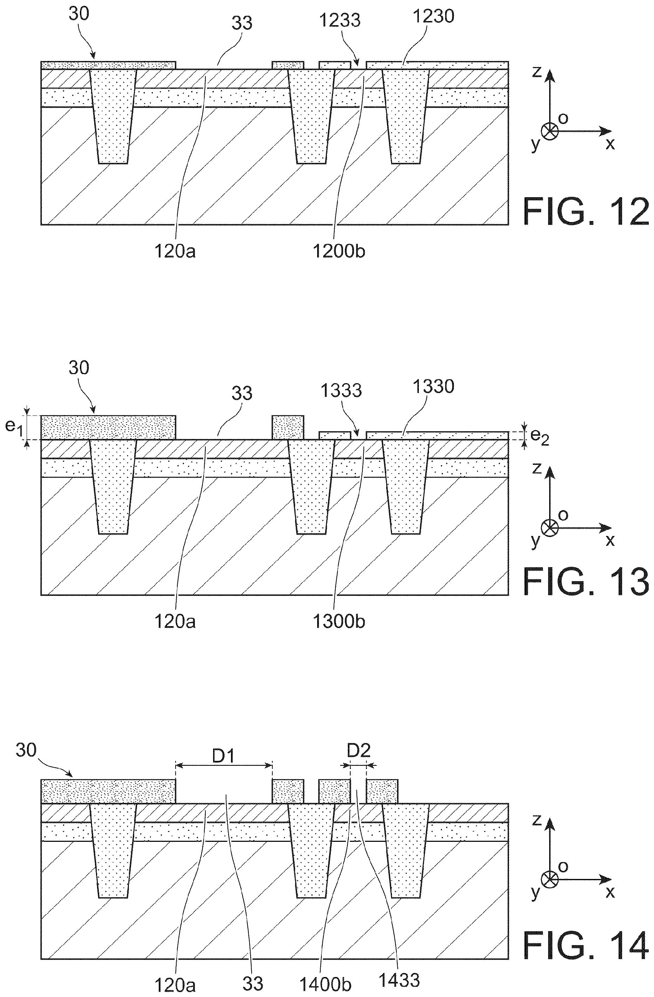

Dans l'exemple de réalisation illustré sur la figure 12, une ouverture 33 est réalisée dans la couche 30 de mise en contrainte, par exemple en nitrure de silicium, en regard d'une région semi-conductrice 120a de la couche superficielle 12. Dans une deuxième couche 1230 de mise en contrainte, par exemple en carbone amorphe ou en TiN, une ouverture 1233 est réalisée en regard d'une autre région semi-conductrice 1200b de ladite couche semi-conductrice superficielle. Une fois ces ouvertures 1233, 33 formées, on effectue au moins recuit pour permettre de réaliser le fluage la couche isolante 11 et relâcher les portions conservées des couches 30, 1230 de mise en contrainte. On modifie ainsi les contraintes respectives dans les régions semi-conductrices 120a, 1200b.

Dans un autre exemple de réalisation illustré sur la figure 13, une couche 30 de mise en contrainte, par exemple en nitrure de silicium, et dans laquelle on pratique une ouverture 33, est prévue avec une première épaisseur e₁, par exemple entre 20 nm et 100 nm. Une autre couche 1330 de mise en contrainte avec une ouverture 1333 est prévue avec une deuxième épaisseur e₂, par exemple entre 20 nm et 100 nm, et qui est différente par rapport à la première épaisseur e₁.

Les couches 30 et 1330 de mise en contrainte peuvent être ici à base d'un même matériau, par exemple du SiN ayant une contrainte en tension. On effectue alors un recuit de fluage de la couche isolante 11, ce qui permet de relâcher les portions restantes des couches 30 et 1330 et modifier l'état de la région semi-conductrice 120a en regard de l'ouverture 33 et de l'autre région 1300b en regard de l'autre ouverture 1333.

On peut de cette manière obtenir des niveaux de contraintes différents respectivement dans une région semi-conductrice 120a en regard de l'ouverture 33 et dans une autre région 1300b en regard de l'autre ouverture 1333 pratiquée dans la couche de mise en contrainte de plus faible épaisseur. Avec une telle variante, en ajustant les épaisseurs respectives e1, e2 en fonction des dimensions des zones actives, on peut également, obtenir des contraintes identiques dans différentes zones actives malgré des tailles respectives différentes de ces zones actives.

Il est également possible, en variante des exemples qui viennent d'être décrits en liaison avec les figures 12 et 13, de réaliser des couches de mise en contrainte sur différentes parties du même substrat ayant à la fois des épaisseurs différentes et des matériaux différents.

Dans un autre exemple de réalisation illustré sur la figure 14, la couche 30 de mise en contrainte comporte une ouverture 33 ayant une première dimension critique D1 et une autre ouverture 1433 ayant une deuxième dimension critique D2 différente de la première D1. Par « dimension critique » on entend, la plus petite dimension d'un motif, ici d'une ouverture, mesurée parallèlement au plan [O ; x ; y] du repère [O ; x ; y ; z] hormis sa hauteur (mesurée parallèlement à l'axe z).

Une fois ces ouvertures 1433, 33 réalisées, on effectue le recuit pour permettre de réaliser le fluage de la couche isolante 11 et relâcher les portions conservées de la couche 30 de mise en contrainte, afin de modifier la contrainte dans des régions semi-conductrices 120a, 1400b situées respectivement en regard de l'ouverture 33 et de l'autre ouverture 1433. On peut ainsi obtenir, dans cet exemple, des contraintes différentes respectivement dans la région semi-conductrice 120a en regard de l'ouverture 33 et dans l'autre région 1400b en regard de l'autre ouverture 1433.

Là encore, avec une telle variante, en ajustant les dimensions respectives D1, D2 en fonction de celles des dimensions des zones actives, on peut également obtenir des contraintes identiques dans différentes zones actives malgré des tailles respectives différentes de ces zones actives.

## Revendications

1. Procédé de modification de l'état de contrainte d'au moins une région semi-conductrice (120a, 412a, 412b, 1112) d'un dispositif semi-conducteur, le procédé comprenant, dans cet ordre, les étapes suivantes :
a) revêtir, une couche semi-conductrice (12) dite « superficielle » d'un substrat de type semi-conducteur sur isolant, d'une couche (30) de mise en contrainte, ledit substrat (5) comprenant, une couche (10) de support, une couche isolante (11) reposant sur la couche de support (10) et ladite couche semi-conductrice superficielle (12) reposant sur ladite couche isolante (11), le substrat (5) comportant des zones d'isolation à base de matériau isolant (23) traversant la couche semi-conductrice (12) superficielle, les tranchées d'isolation (21) étant agencées de part et d'autre d'une zone semi-conductrice (120) dite « active » comprenant une première région semi-conductrice (120a), puis
b) former dans la couche (30) de mise en contrainte, au moins une ouverture (33 ; 433₁, 433₂, 1133) traversant la couche (30) de mise en contrainte et agencée en regard de la première région semi-conductrice (120a, 412a, 412b, 1112) de ladite couche semi-conductrice superficielle tout en conservant au moins une portion (30B, 430B, 430D) de la couche (30) de mise en contrainte sur et en regard d'au moins une partie du substrat, ladite partie étant disposée contre et en contact de la première région semi-conductrice (120a), puis,
c) effectuer un recuit dit « de fluage » selon une durée et une température adaptées pour permettre le fluage de la couche isolante (11) du substrat et relâcher ladite portion (30B, 430B, 430D) de la couche de mise en contrainte de sorte à modifier un état de contrainte de la première région semi-conductrice (120a ; 412a, 412b).

2. Procédé selon la revendication 1, dans lequel l'ouverture (33 ; 433₁, 433₂, 1133) agencée en regard de la première région semi-conductrice (120a, 412a, 412b, 1112) est centrée par rapport à une première tranchée d'isolation (21) et à une deuxième tranchée d'isolation disposées de part et d'autre de la première région semi-conductrice.

3. Procédé selon l'une des revendications 1 ou 2, dans lequel ladite partie est une deuxième région semi-conductrice (120b) de ladite couche semi-conductrice superficielle disposée contre et en contact la première région semi-conductrice (120a) et dans lequel ladite ouverture (33) est réalisée de sorte à conserver une deuxième portion (30C) de la couche (30) de mise en contrainte en regard d'au moins une troisième région (120c) de la couche semi-conductrice (12) superficielle disposée contre et en contact de la première région semi-conductrice (120a), ladite au moins une portion (30B) de la couche (30) de mise en contrainte et ladite deuxième portion (30C) étant agencées de part et d'autre de ladite ouverture (33), la deuxième région semi-conductrice (120b) et la troisième région (120c) semi-conductrice étant agencées de part et d'autre de la première région semi-conductrice (120a).

4. Procédé selon la revendication 3, dans lequel la couche (30) de mise en contrainte dans laquelle on forme l'ouverture (33) à l'étape b) comporte une contrainte en tension et dans lequel à l'étape c) de recuit, le fluage de la couche isolante (11) du substrat et le relâchement des portions (30B, 30C) de la couche (30) de mise en contrainte entrainent une mise en compression de la deuxième région semi-conductrice (120b) et de la troisième région semi-conductrice (120c), de sorte à mettre en tension la première région semi-conductrice (120a).

5. Procédé selon la des revendications 1 à 4, dans lequel la première région semi-conductrice (120a) appartient à une zone semi-conductrice (120) dite « zone active » destinée à accueillir au moins un transistor (T₁) de type N, et dans lequel ladite ouverture (33) est réalisée de sorte à conserver une portion de la couche (30) de mise en contrainte en regard d'une autre zone active, l'autre zone active étant destinée à accueillir un ou plusieurs transistors (T₂, T₃) de type P.

6. Procédé selon l'une des revendications 1 à 5, dans lequel, après formation de ladite ouverture (1133) et préalablement audit recuit de fluage, le procédé comprend en outre le dépôt d'une deuxième couche (1150) de mise en contrainte sur la couche (30) de mise en contrainte ainsi que sur la première région semi-conductrice (1112).

7. Procédé selon l'une des revendications 1 à 6, dans lequel on forme dans la couche (30) de mise en contrainte, une deuxième ouverture (1433) dévoilant une autre région semi-conductrice (1400b) de ladite couche semi-conductrice superficielle (12), ladite au moins une ouverture (33) et ladite deuxième ouverture (1433) ayant des dimensions respectives (D1, D2) différentes.

8. Procédé selon l'une des revendications 1 à 7, dans lequel, préalablement à l'étape de recuit de fluage, une partie du substrat est revêtue par une deuxième couche (1330) de mise en contrainte différente de ladite couche (30) de mise en contrainte et/ou d'épaisseur différente de ladite couche (30) de mise en contrainte, le procédé comprenant en outre préalablement à l'étape de recuit de fluage, la réalisation d'au moins une ouverture dans la deuxième couche (1330) de mise en contrainte dévoilant une autre région semi-conductrice (1300b) de ladite couche semi-conductrice superficielle.

9. Procédé selon l'une des revendications précédentes, dans lequel le matériau de la couche (30) de mise en contrainte est du nitrure de silicium contraint en tension.

10. Procédé selon l'une des revendications précédentes dans lequel la couche (30) de mise en contrainte a une épaisseur comprise entre 20 nm et 100 nm.

11. Procédé selon l'une des revendications 1 à 10, dans lequel le recuit de fluage à l'étape b) est effectué à une température comprise entre 900°C et 1200°C, en particulier pendant une durée comprise entre 1 et 30 minutes.

12. Procédé selon l'une des revendications 1 à 11, dans lequel ladite première région semi-conductrice (12a) est à base de Si, et dans lequel, au moins une autre zone semi-conductrice (221, 222) du substrat revêtue par la couche (30) de mise en contrainte est en SiₓGe₁₋ₓ (avec 0 < x < 1).

13. Procédé selon la revendication 12, dans lequel ladite au moins une autre zone semi-conductrice (221, 222) est une zone enrichie en Germanium de la couche semi-conductrice superficielle (12), la couche semi-conductrice superficielle (12) étant en silicium, le procédé comprenant, préalablement à l'étape a), des étapes de :
- formation d'un bloc (54b, 54c) en silicium Germanium sur l'autre zone semi-conductrice,
- oxydation thermique du bloc semi-conducteurs (54b, 54c) en silicium Germanium et de ladite couche semi-conductrice superficielle de sorte à réaliser un enrichissement en germanium de l'autre zone semi-conductrice (12).

14. Procédé de réalisation d'un dispositif à transistors, comprenant :
- la mise en œuvre d'un procédé selon l'une des revendications 1 à 13, puis, après l'étape c) de recuit de fluage,
- le retrait de la couche de mise en contrainte, le procédé comprenant en outre, après retrait de la couche de mise en contrainte : la formation d'au moins un transistor (T₁) dans la première région semi-conductrice (12a) et d'au moins un autre transistor (T₂) dans une autre région semi-conductrice de la couche superficielle du substrat.
